# EUROPEAN PATENT APPLICATION

(11) **EP 4 492 460 A1**
(43) Date of publication of application: **15.01.2025**
(21) Application number: 23766943.7
(22) Date of filing: 09.03.2023
(51) Int. Cl.: H01L 25/07, H01L 25/18

(54) **SEMICONDUCTOR MODULE, POWER CONVERSION DEVICE, AND METHOD FOR MANUFACTURING SEMICONDUCTOR MODULE**

(30) Priority: 11.03.2022 JP 2022038337
(71) Applicant: Nidec Corporation, Minami-ku, Kyoto-shi, Kyoto 601-8205 (JP)
(72) Inventor: OBARA, Teppei, Kyoto-shi, Kyoto 601-8205 (JP)
(74) Representative: SSM Sandmair
(86) International application number: PCT/JP2023/009165
(87) International publication number: WO 2023/171767

(57) **Abstract**

A semiconductor module according to one aspect of the present disclosure includes a semiconductor chip and an electrode pattern. The semiconductor chip is provided on an insulating substrate fixed to a base plate. The electrode pattern is provided on a peripheral edge portion on the insulating substrate and connected to an electrode pad of the semiconductor chip, and is connected to a control pin extending from a case as the case is assembled to the base plate.

## Description

### TECHNICAL FIELD

The present disclosure relates to a semiconductor module, a power conversion device, and a method of manufacturing a semiconductor module.

### BACKGROUND ART

Patent Literature 1 discloses a semiconductor module in which a semiconductor chip assembled in a case and a control pin extending from the case are connected by the same line such as an aluminum wire.

### CITATIONS LIST

### PATENT LITERATURE

Patent Literature 1: WO 2018/087890 A

### SUMMARY OF INVENTION

### TECHNICAL PROBLEMS

The above-described conventional technique has room for further improvement in terms of simplifying a process of connecting the semiconductor chip and the control pin.

The present disclosure provides a technique capable of simplifying a process of connecting a semiconductor chip and a control pin.

### SOLUTIONS TO PROBLEMS

A semiconductor module according to one aspect of the present disclosure includes a semiconductor chip and an electrode pattern. The semiconductor chip is provided on an insulating substrate fixed to a base plate. The electrode pattern is provided on a peripheral edge portion on the insulating substrate and connected to an electrode pad of the semiconductor chip, and is connected to a control pin extending from a case as the case is assembled to the base plate.

### ADVANTAGEOUS EFFECTS OF INVENTION

According to the present disclosure, a process of connecting a semiconductor chip and a control pin can be simplified.

### BRIEF DESCRIPTION OF DRAWINGS

FIG. 1 is a perspective view illustrating a semiconductor module before assembly according to a comparative example.
FIG. 2 is a perspective view illustrating the semiconductor module after assembly according to the comparative example.
FIG. 3 is an explanatory diagram illustrating a connection portion between an electrode pad of a semiconductor chip and a control pin according to the comparative example.
FIG. 4 is a perspective view illustrating a semiconductor module according to a first embodiment.
FIG. 5 is an explanatory view illustrating a connection portion between an electrode pad of a semiconductor chip and an electrode pattern according to the first embodiment.
FIG. 6 is a schematic plan view of the semiconductor module according to the first embodiment.
FIG. 7 is a schematic side view illustrating a positional relationship between a bus bar and a bonding wire according to the first embodiment.
FIG. 8 is a schematic side view illustrating a positional relationship between the bus bar and the bonding wire according to a variation of the first embodiment.
FIG. 9 is a schematic plan view of the semiconductor module according to a second embodiment.

### DESCRIPTION OF EMBODIMENTS

Hereinafter, a mode (hereinafter, described as an "embodiment") for carrying out a semiconductor module, a power conversion device, and a method of manufacturing a semiconductor module according to the present disclosure will be described in detail with reference to the drawings. Note that the present disclosure is not limited by this embodiment. Further, each embodiment can be appropriately combined within a range in which there is no contradiction in processing content. Further, in each embodiment below, the same reference numerals are given to constituent elements having the same function, and redundant description will be omitted.

Further, in an embodiment described below, there is a case where expressions such as "constant", "orthogonal", "vertical", and "parallel" is used, but these expressions do not need to strictly mean "constant", "orthogonal", "vertical", and "parallel". That is, each of the expressions described above is assumed to allow deviation in manufacturing accuracy, installation accuracy, and the like, for example.

### <First embodiment>

### <Semiconductor module according to comparative example>

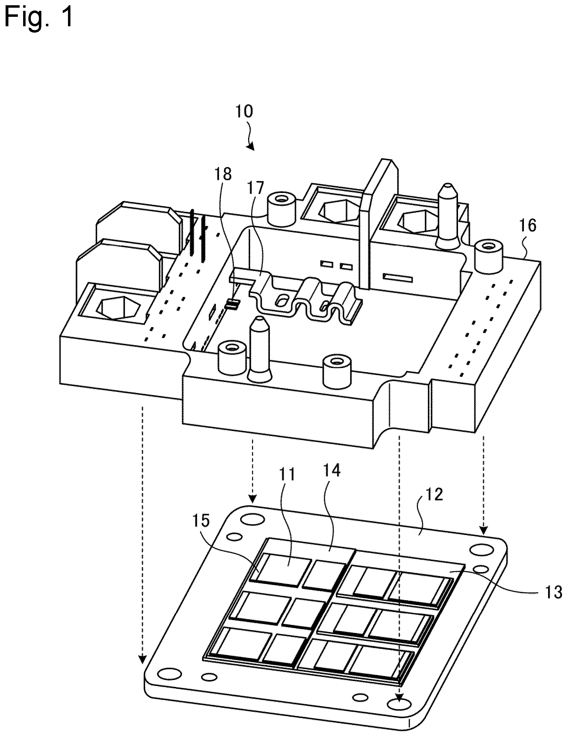

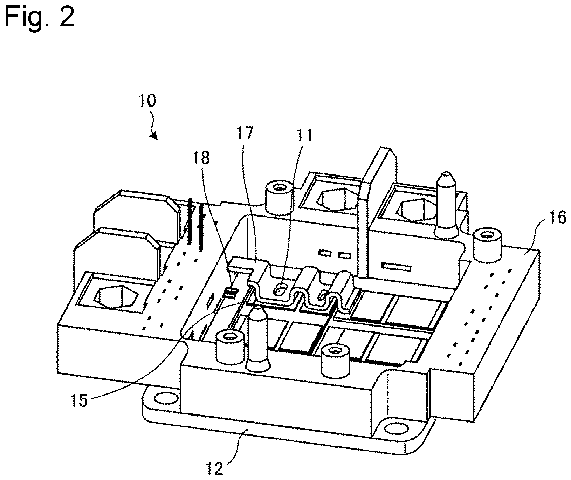

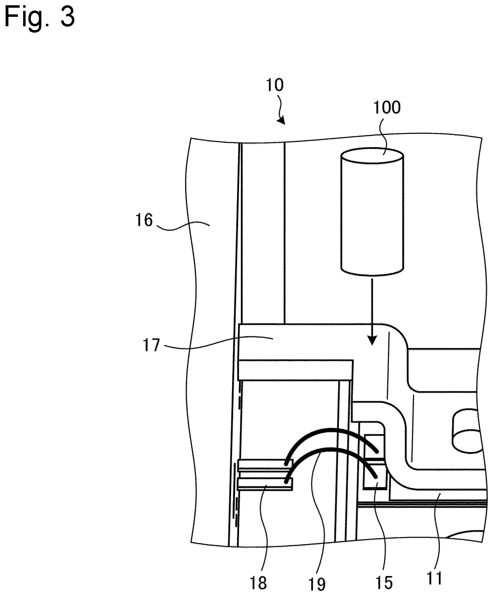

First, a semiconductor module 10 according to a comparative example of the present disclosure will be described with reference to FIGS. 1 to 3. FIG. 1 is a perspective view illustrating the semiconductor module 10 before assembly according to the comparative example. FIG. 2 is a perspective view illustrating the semiconductor module 10 after assembly according to the comparative example. FIG. 3 is an explanatory diagram illustrating a connection portion between an electrode pad 15 of a semiconductor chip 11 and a control pin 18 according to the comparative example.

The semiconductor module 10 according to the comparative example constitutes, for example, a part of a power conversion device that converts DC power supplied from a DC power supply into AC power. As illustrated in FIG. 1, the semiconductor module 10 according to the comparative example includes the semiconductor chip 11 provided on an insulating substrate 13 fixed to a base plate 12 via a copper pattern 14, and a case 16.

Here, six of the semiconductor chips 11 are arranged on the insulating substrate 13. Each of the semiconductor chips 11 is, for example, an insulated gate bipolar transistor (IGBT). Six of the semiconductor chips 11 form a bridge circuit that converts DC power into AC power. The semiconductor chip 11 includes, for example, the electrode pad 15 connected to a gate of an IGBT. A control signal for turning on or off an IGBT is input to the electrode pad 15 from an external control device.

The case 16 is a frame body made from resin and having a frame shape in which an opening is provided so as to surround a region where the insulating substrate 13 is arranged in the base plate 12. The case 16 includes a bus bar 17 extending in a direction parallel to a plane direction of the base plate 12 from an inner peripheral surface of the opening toward the inside of the opening, and a control pin 18.

The bus bar 17 is a terminal for inputting power from an external DC power supply to an IGBT. The control pin 18 is a terminal for inputting a control signal from an external control device to the electrode pad 15.

As illustrated in FIG. 2, in the semiconductor module 10, the case 16 is assembled on the base plate 12 on which the semiconductor chip 11 is arranged, so that a connection pad for power supply provided on an upper surface of the semiconductor chip 11 and the bus bar 17 are electrically connected. The bus bar 17 and the connection pad for power supply on the semiconductor chip 11 are connected by, for example, solder.

After the above, as illustrated in FIG. 3, the control pin 18 and the electrode pad 15 for a control signal are wire-bonded by a wire connection device 100, for example. By the above, the control pin 18 and the electrode pad 15 are electrically connected by a bonding wire 19.

At this time, in the semiconductor module 10, the electrode pad 15 for a control signal and a part of the bus bar 17 may overlap in plan view. In this case, the wire connection device 100 interferes with the bus bar 17 only by movement in a horizontal direction and a vertical direction, and the electrode pad 15 for a control signal and the control pin 18 cannot be connected. For this reason, for example, the wire connection device 100 requires complicated control such as setting a moving direction to an oblique direction.

On the other hand, for example, in a case where the electrode pad 15 for a control signal and the control pin 18 are connected before the case 16 is fixed to the base plate 12, it is necessary to connect the case 16 in a state of being slightly shifted in the horizontal direction with respect to the base plate 12.

In this case, in a process of fixing the case 16 to the base plate 12, it is necessary to horizontally move the case 16 to a fixing position, and the bonding wire 19 may be disconnected by this movement. As described above, in the semiconductor module 10 according to the comparative example, the process of connecting the semiconductor chip 11 and the control pin 18 is complicated. In view of the above, a semiconductor module according to a first embodiment has a configuration capable of simplifying a process of connecting the semiconductor chip 11 and the control pin 18.

### <Semiconductor module according to first embodiment>

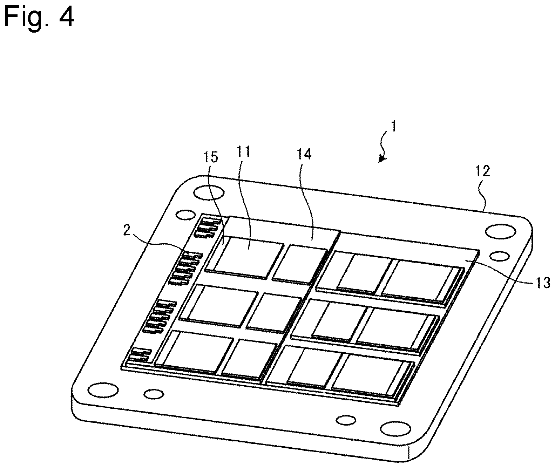

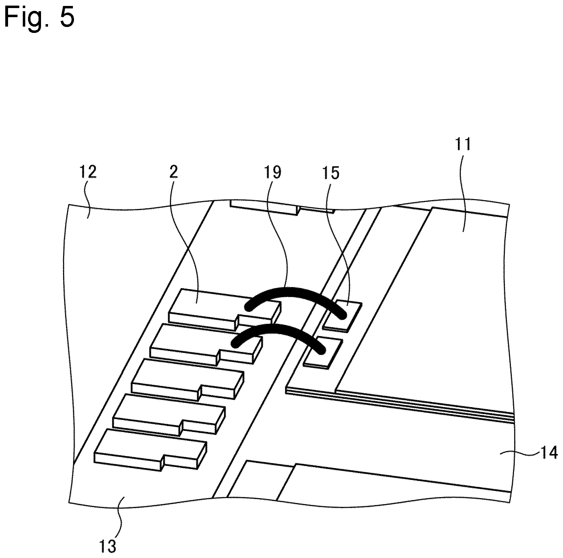

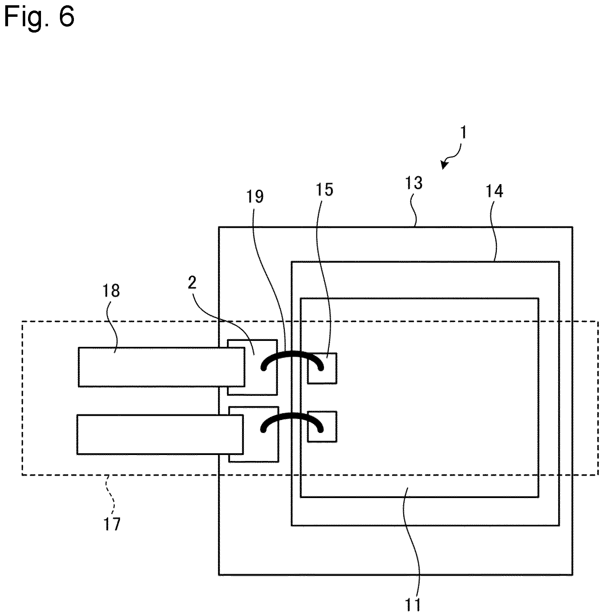

Next, a semiconductor module 1 according to the first embodiment will be described with reference to FIGS. 4 to 6. FIG. 4 is a perspective view illustrating the semiconductor module 1 according to the first embodiment. FIG. 5 is an explanatory view illustrating a connection portion between the electrode pad 15 of the semiconductor chip 11 and an electrode pattern 2 according to the first embodiment. FIG. 6 is a schematic plan view of the semiconductor module 1 according to the first embodiment. Note that in FIGS. 4 and 6, illustration of the case 16 is omitted in order to clearly illustrate a characteristic configuration of the semiconductor module 1.

As illustrated in FIG. 4, the semiconductor module 1 includes the semiconductor chip 11 provided on the insulating substrate 13 fixed to the base plate 12 via the copper pattern 14, similarly to the semiconductor module 10 according to the comparative example.

Furthermore, the semiconductor module 1 includes the electrode pattern 2 provided on a peripheral edge portion on the insulating substrate 13 and connected to the electrode pad 15 of the semiconductor chip 11, and connected to the control pin 18 extending from the case 16 as the case 16 is assembled to the base plate 12.

Specifically, the electrode pad 15 is provided on a main surface on the opposite side to a main surface facing the insulating substrate 13 of the semiconductor chip 11. On the other hand, the electrode pattern 2 is provided at a position abutting on the control pin 18 when the case 16 is assembled to the base plate 12 in a peripheral edge portion on the insulating substrate 13.

Then, as illustrated in FIG. 5, the electrode pattern 2 is electrically connected to the electrode pad 15 for a control signal in the semiconductor chip 11 by the bonding wire 19 before the case 16 is assembled to the base plate 12.

By the above, in the semiconductor module 1, the electrode pattern 2 and the control pin 18 are electrically connected at the same time in the process of assembling the base plate 12 to the case 16, so that the process of connecting the semiconductor chip 11 and the control pin 18 can be simplified. The electrode pattern 2 and the control pin 18 may be connected by solder, but are preferably connected by ultrasonic bonding.

Further, as illustrated in FIG. 6, in the semiconductor module 1, in a case where the electrode pad 15 for a control signal in the semiconductor chip 11 and a part of the bus bar 17 overlap in plan view, the semiconductor chip 11 and the control pin 18 can be connected without performing a complicated connection process.

Further, in the semiconductor module 1, in the process of assembling the base plate 12 to the case 16, a positional relationship between the electrode pattern 2 connected by the bonding wire 19 and the electrode pad 15 does not change, so that disconnection of the bonding wire 19 can be prevented.

### <Method of manufacturing semiconductor module according to first embodiment>

Next, a method for manufacturing the semiconductor module 1 will be described. In a case of manufacturing the semiconductor module 1, first, the electrode pattern 2 and the copper pattern 14 are formed in a peripheral edge portion on the insulating substrate 13.

Subsequently, the semiconductor chip 11 is assembled on the insulating substrate 13 via the copper pattern 14. After that, the electrode pad 15 of the semiconductor chip 11 and the electrode pattern 2 are connected by, for example, the bonding wire 19.

Then, by assembling the case 16 to the base plate 12 to which the insulating substrate 13 is fixed, the control pin 18 extending from the case 16 and the electrode pattern 2 are caused to abut on each other. After that, the control pin 18 and the electrode pattern 2 are electrically connected by ultrasonic bonding to complete the semiconductor module 1.

### <Semiconductor module according to variation of first embodiment>

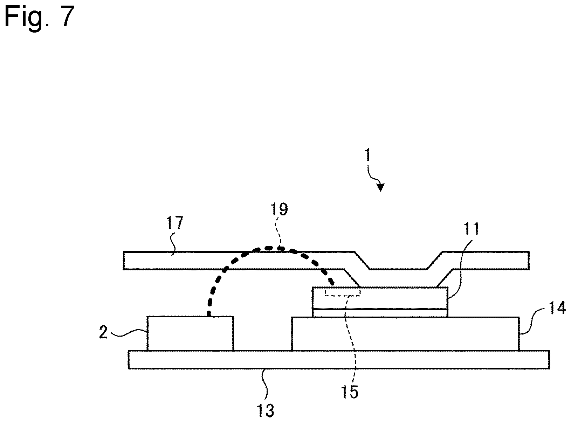

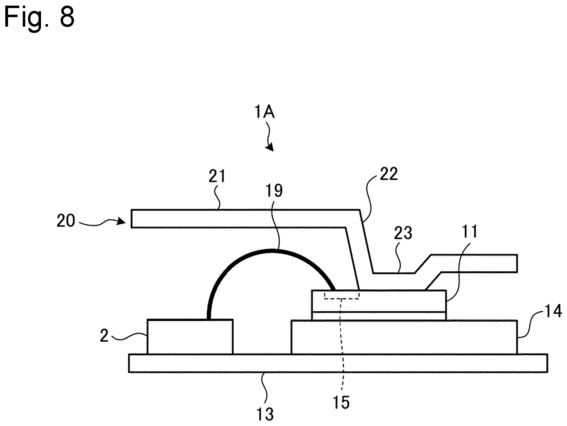

Next, a semiconductor module 1A according to a variation of the first embodiment will be described with reference to FIGS. 7 and 8. FIG. 7 is a schematic side view illustrating a positional relationship between the bus bar 17 and the bonding wire 19 according to the first embodiment. FIG. 8 is a schematic side view illustrating a positional relationship between a bus bar 20 and the bonding wire 19 according to the variation of the first embodiment.

As illustrated in FIG. 7, in the semiconductor module 1 according to the first embodiment, for example, a highest position of the bonding wire 19 may become higher than a height position of the bus bar 17 due to control accuracy of the wire connection device 100, and the bonding wire 19 and the bus bar 17 may interfere with each other.

In view of the above, as illustrated in FIG. 8, the semiconductor module 1A according to the variation of the first embodiment includes the case 16 including the bus bar 20 having a shape different from that of the semiconductor module 1 according to the first embodiment. Note that a shape of the case 16 and a position of the control pin 18 are the same as those of the case according to the first embodiment.

Specifically, the bus bar 20 according to the variation of the first embodiment includes a first portion 21, a second portion 22, and a third portion 23. The first portion 21 overlaps the control pin 18 in plan view, and extends from a position higher than a height position of the control pin 18 in the case 16 to a position beyond the electrode pad 15 in a direction parallel to an extending direction of the control pin 18.

The second portion 22 extends downward from a tip of the first portion 21. The third portion 23 extends in a direction parallel to an extending direction of the first portion 21 from a tip of the second portion 22 and is connected to the semiconductor chip 11. Then, the first portion 21 is configured to have a height position higher than a highest position of the bonding wire 19. By the above, the bus bar 20 according to the variation can be prevented from interfering with the bonding wire 19.

### <Second embodiment>

### <Semiconductor module according to second embodiment>

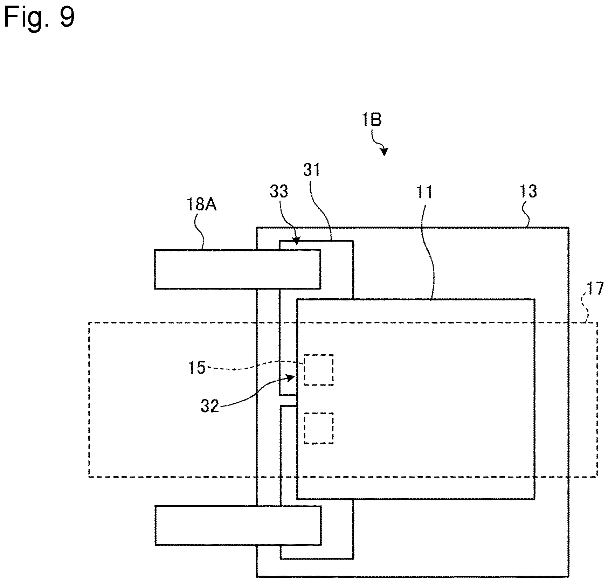

Next, a semiconductor module 1B according to a second embodiment will be described with reference to FIG. 9. FIG. 9 is a schematic plan view of the semiconductor module 1B according to the second embodiment.

In the semiconductor module 1 according to the first embodiment, as illustrated in FIG. 6, the electrode pattern 2 connected to the electrode pad 15 by the bonding wire 19 is provided at a position between the electrode pad 15 of the semiconductor chip 11 in the insulating substrate 13 and the control pin 18.

By the above, in the semiconductor module 1 according to the first embodiment, as described above, a connection process between the semiconductor chip 11 and the control pin 18 can be simplified, but a space for providing the electrode pattern 2 on the insulating substrate 13 at an interval from the electrode pad 15 is required. By the above, it is necessary to increase size of the insulating substrate 13.

In view of the above, as illustrated in FIG. 9, in the semiconductor module 1B according to the second embodiment, the electrode pad 15 is provided on a main surface facing the insulating substrate 13 of the semiconductor chip 11. Specifically, in the semiconductor module 1B, the semiconductor chip 11 illustrated in FIG. 6 is arranged on the insulating substrate 13 in a state of being reversed.

Further, in the semiconductor module 1B, an electrode pattern 31 is arranged between the insulating substrate 13 and the electrode pad 15 in the semiconductor chip 11 such that a longitudinal direction intersects an extending direction of a control pin 18A.

Further, a pair of the control pins 18A are arranged at longer intervals than one side of the semiconductor chip 11. Then, the electrode pattern 31 is connected to the electrode pad 15 at one end portion 32 in a longitudinal direction and connected to the control pin 18A at another end portion 33. The electrode pattern 31, the electrode pad 15, and the control pin 18A may be connected by solder, but are preferably connected by ultrasonic bonding.

By the above, in the semiconductor module 1B, a space for providing the electrode pattern 2 at an interval from the electrode pad 15 is not necessary on the insulating substrate 13, and thus, it is not necessary to increase size of the insulating substrate 13, and cost can be reduced.

Further, in the semiconductor module 1B, since the electrode pad 15 and the control pin 18A are connected not by the bonding wire 19 but by the electrode pattern 31, risk of occurrence of disconnection can be reduced as compared with the connection by the bonding wire 19.

Note that, in the example illustrated in FIG. 9, the electrode pattern 31 is arranged such that a longitudinal direction intersects an extending direction of the control pin 18A, but may be arranged such that the longitudinal direction is parallel to the extending direction of the control pin 18A.

In this case, the control pins 18A are arranged at the same interval as an interval between a pair of the electrode pads 15. The electrode pattern 31 is provided on the insulating substrate 13 so as to overlap a curve connecting the control pin 18A and the electrode pad 15 in plan view. Then, the electrode pattern 31 is connected to a lower surface of the electrode pad 15 on an upper surface of the one end portion 32 in the longitudinal direction, and is connected to a lower surface of the control pin 18A on an upper surface of the another end portion 33.

Also in this case, a space for providing the electrode pattern 2 at an interval from the electrode pad 15 is unnecessary on the insulating substrate 13, and the electrode pad 15 and the control pin 18A are connected by the electrode pattern 31 instead of the bonding wire 19. By the above, similarly to the semiconductor module 1B illustrated in FIG. 9, it is possible to reduce cost and risk of occurrence of disconnection.

### REFERENCE SIGNS LIST

1, 1A, 1B, 10 semiconductor module
11 semiconductor chip
2, 31 electrode pattern
12 base plate
13 insulating substrate
14 copper pattern
15 electrode pad
16 case
17, 20 bus bar
18, 18A control pin
19 bonding wire
21 first portion
22 second portion
23 third portion
32 one end portion
33 another end portion
100 wire connection device

## Claims

1. A semiconductor module comprising:
a semiconductor chip provided on an insulating substrate fixed to a base plate; and
an electrode pattern provided on a peripheral edge portion on the insulating substrate, connected to an electrode pad of the semiconductor chip, and connected to a control pin extending from a case as the case is assembled to the base plate.

2. The semiconductor module according to claim 1, wherein
the electrode pad is provided on a main surface on an opposite side to a main surface facing the insulating substrate in the semiconductor chip, and is connected to the electrode pattern by a bonding wire.

3. The semiconductor module according to claim 2, further comprising a case, wherein
the case includes a bus bar connected to the semiconductor chip by being assembled to the base plate,
the bus bar includes:
a first portion overlapping the control pin in plan view and extending from a position higher than a height position of the control pin in the case to a position beyond the electrode pad in a direction parallel to an extending direction of the control pin;
a second portion extending downward from a tip of the first portion; and
a third portion extending in a direction parallel to an extending direction of the first portion from a tip of the second portion and connected to the semiconductor chip, and
the first portion has a height position higher than a highest position of the bonding wire.

4. The semiconductor module according to claim 1, wherein
the electrode pad is provided on a main surface facing the insulating substrate in the semiconductor chip, and
the electrode pattern is connected to the electrode pad in one end portion in a longitudinal direction and connected to the control pin in another end portion.

5. The semiconductor module according to claim 4, wherein
the electrode pattern is arranged such that the longitudinal direction intersects an extending direction of the control pin.

6. A power conversion device comprising the semiconductor module according to any one of claims 1 to 5.

7. A method of manufacturing a semiconductor module, the method comprising:
forming an electrode pattern on a peripheral edge portion on an insulating substrate;
assembling a semiconductor chip on the insulating substrate;
connecting an electrode pad of the semiconductor chip and the electrode pattern; and
connecting a control pin extending from a case and the electrode pattern by assembling the case to a base plate to which the insulating substrate is fixed.
